(19)

Europäisches
Patentamt
European
Patent Office
Office européen
des brevets

(11) **EP 2 120 123 A1**

(12) **EUROPEAN PATENT APPLICATION**

(43) Date of publication:
**18.11.2009 Bulletin 2009/47**

(51) Int Cl.:
*G05F 1/46* (2006.01)     *H03K 17/082* (2006.01)

(21) Application number: **08305162.3**

(22) Date of filing: **12.05.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(71) Applicants:
• **STMicroelectronics SA
92120 Montrouge (FR)**
• **STMicroelectronics Design and Application
S.R.O.
186 00 Praha 8 (CZ)**

(72) Inventors:
• **Lenz, Kuno
38340, VOREPPE (FR)**
• **Napravnik, Karel
160 00, PRAHA (CZ)**

(74) Representative: **de Beaumont, Michel
1bis, rue Champollion
38000 Grenoble (FR)**

(54) **Slew rate control**

(57)     The invention concerns a circuit comprising an output stage (PM1) and a differentiator coupled between an output (2) of the output stage and a control node of the output stage. The invention also concerns a method for controlling the slew rate of an output stage.

Fig 2

## Description

<u>Field</u>

The present invention concerns voltage regulators and amplifiers, in particular the controlling of output slew rates of such circuits.

<u>Relevant background</u>

The power supplies of electronic equipment, either mobile or fixed, are often not stable enough for the integrated circuits they supply to operate as required. Therefore voltage regulators are frequently used to provide stable voltages having reduced levels of the transients and other variations to other circuits.

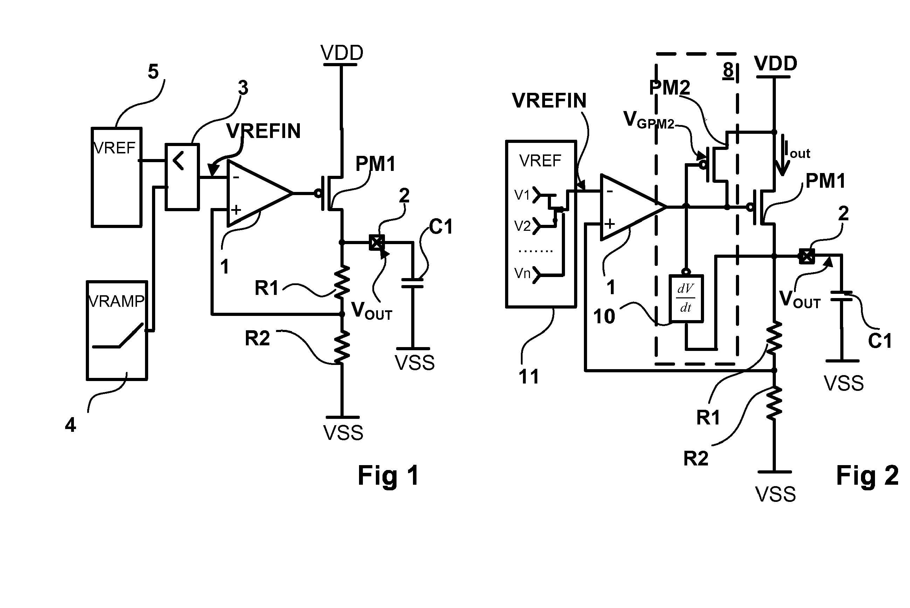

In Fig 1, an example of a voltage regulator is shown. An operational amplifier **1** drives an output pMOS transistor **PM1** which has its source connected to a high supply rail, **VDD,** and its drain connected to an output pad **2,** the voltage at which is henceforth referred to as '$V_{OUT}$'. The source of transistor **PM1** is connected to a negative supply **VSS** via a resistor bridge composed of two resistors, **R1** and **R2.** The non-inverting input of the operational amplifier **1** is connected to the common point between the two resistors **R1, R2** so as to form a feedback loop which sets the closed loop gain of amplification circuit comprising the operational amplifier **1** and the resistors **R1, R2.** The above circuit can be seen as a voltage follower, where voltage $V_{OUT}$ tracks the voltage at the inverting input, henceforth referred to as **'VREFIN'.** Transistor **PM1** is designed to provide sufficient current for the requirements of all the other circuits connected to the output pad **2** and so is generally a large transistor.

The output pad **2** is connected via a capacitor **C1** to the negative supply **VSS.**

When the regulator is powered up, the capacitor **C1** is charged. Since this capacitor has to be large enough to smooth the regulated supply effectively and transistor **PM1** has a high current supplying capability, the current drawn by the charging will be significant and can cause a number of problems including electromagnetic interference and transient drops in power supply voltage.

This problem is particularly acute in battery powered mobile devices, where the resultant charging currents, which are in the order of many tens or hundreds of milliamps, can cause significant drops in the voltage delivered by the battery.

Fig 1 also shows, as disclosed in French patent application 2872305, a solution for controlling the slew rate at the regulator output during power-up. The operational amplifier **1** receives its inverting input via a selector **3.** During the power-up phase, the selector **3** connects a voltage ramp generator **4** (VRAMP) to provide voltage **VREFIN.** When the steady-state voltage of the voltage regulator has been reached, the selector **3** automatically connects a voltage reference **5** (VREF) to provide voltage **VREFIN.** The rise time of the ramp generator, which determines the slew rate of the regulator output, is chosen so as to avoid the problems described above.

However, it is often required of voltage regulators that they be able to supply multiple steady-state voltages. Such changing of the output voltage of a regulator is called voltage scaling. Whenever the voltage is increased, a large current will be drawn, as during power-up, to charge the capacitor. Thus there is also a need for controlling the slew rate during voltage scaling.

<u>Summary</u>

Controlling the slew rate during start-up and voltage scaling is achieved according to an embodiment by providing a circuit comprising:

- an output stage;
- a differentiator coupled between an output of the output stage and a control node of the output stage.

According to an embodiment, there is provided a circuit wherein the differentiator comprises:

- a limiting transistor coupled between the control node of the output stage and a first supply voltage a current mirror having an output branch coupled to a control terminal of the limiting transistor;
- a capacitor having a first terminal coupled to the output of the output stage and a second terminal coupled to an input branch of the current mirror; and
- a first current source coupled between the first supply voltage and the control terminal of the limiting transistor.

According to an embodiment, there is provided a circuit further comprising:

- a first switch coupled between the input branch of the current mirror and the second terminal of the capacitor; and
- a second switch coupled between the first supply voltage and the second terminal of the capacitor.

According to an embodiment, there is provided a circuit further comprising:

- a second current source coupled between the first supply voltage and the input branch of the current mirror; and
- a current reference supplying a current reference value to first and second currents sources.

According to an embodiment, there is provided a circuit further comprising:

- an amplifier having an output coupled to a control node of the output stage;

- a voltage reference coupled to an input of the operational amplifier; and
- a feedback loop from the output of the output stage to the input of the amplifier that permits the circuit to function as a voltage regulator.

According to an embodiment, there is provided a circuit to which a slew rate limiting circuit is coupled having an output slew rate less than 10,000 volts per second.

According to an embodiment, there is provided a portable electronic equipment comprising a circuit according to an embodiment.

According to an embodiment, there is provided a method of controlling the output slew rate of an output stage of a circuit, comprising the steps of:

- measuring the voltage at the output of the output stage;
- differentiating the measured voltage to produce a differentiated value;
- limiting the slew rate of a voltage applied to a controlling node of the output stage, based on the differentiated value.

According to an embodiment, there is provided a method wherein the step of limiting the slew rate of the voltage applied to the controlling node of the output stage is achieved by supplying a current to the controlling node of the output stage in a manner proportional to the differentiated value.

According to an embodiment, there is provided a method wherein the step of differentiating the measured voltage is achieved by differentiating the measured voltage to produce a current and multiplying the current by a predetermined value.

*Brief description of the drawings*

Various embodiments are shown in the accompanying drawings, wherein:

Figure 1 schematically represents a voltage regulator incorporating a solution for controlling the output slew rate during the power-up phase of the voltage regulator.

Figure 2 schematically represents a voltage regulator incorporating an embodiment and a solution for performing voltage scaling.

Figure 3 represents the operation of an embodiment in terms of the variation with time of certain voltages and currents.

Figure 4 schematically represents a voltage regulator incorporating an embodiment.

Figure 5 schematically represents a voltage differentiator used in embodiments, simplified to illustrate the principles of operation.

Figure 6 represents the operation of the embodiment shown in Figure 5 in terms of the variation with time of certain voltages.

Figure 7 schematically represents the voltage differentiator of Fig 4 with circuitry for improvement of the performance during the very early stages of power-up.

Figure 8 represents the operation of the embodiment with the improvement shown in Figure 7 in terms of the variation with time of certain voltages.

Figure 9 schematically represents the voltage differentiator of Fig 4 with alternative circuitry for improvement of the performance during the very early stages of power-up.

Figure 10 schematically represents an implementation of a voltage regulator incorporating an embodiment in a battery powered mobile device containing a plurality of integrated circuits.

Detailed description of the preferred embodiments

In the description below, certain elements of a voltage regulator are implemented as described in Fig1 and are not described further and, throughout, same references designate same elements.

Fig 2 shows a low drop-out regulator, or LDO, including an embodiment of a slew rate control circuit **8**. A differentiator **10** has an input receiving the output of the voltage regulator, $V_{OUT}$, and drives the gate of a second pMOS transistor **PM2**. Transistor **PM2** has its source connected to the gate of transistor **PM1** and its drain connected to the positive supply **VDD**. The operational amplifier **1** receives its inverting input from a voltage reference **11** (VREF) which incorporates circuitry for providing multiple reference voltages in order to provide voltage scaling. The circuitry for providing multiple reference voltages is here represented as a selector though other solutions are possible.

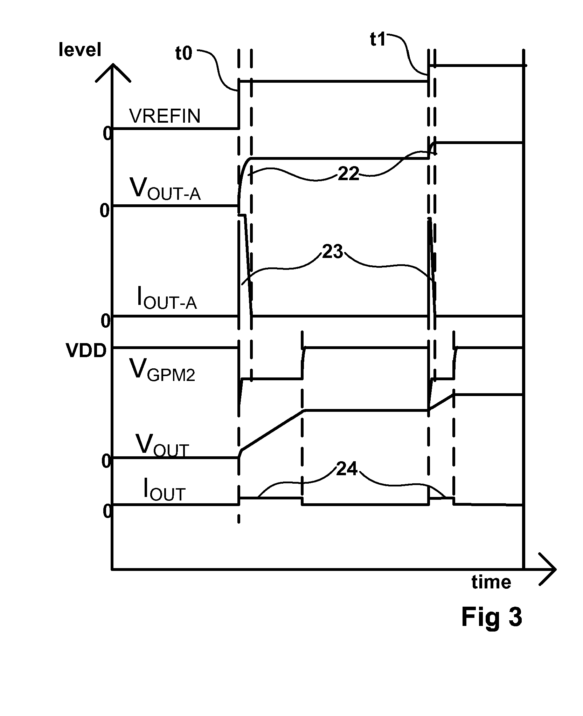

Fig 3 shows the general principles of the operation of an embodiment in terms of the variation with time of voltages and currents. Voltage **VREFIN** is increased at start-up **t0** and at a later time **t1** during voltage scaling. $V_{OUT-A}$ designates the voltage $V_{OUT}$ which would occur in a voltage regulator implemented without the embodiment. As shown by $V_{OUT-A}$, the output voltage exhibits high slew rates **22** at start-up and during voltage scaling. The high slew rates **22** of voltage $V_{OUT-A}$ result in large peaks **23** in the current $I_{OUT-A}$ flowing from **VDD**, through transistor **PM1**, into capacitor **C1**.

However, in a voltage regulator implemented with an embodiment, the voltage differentiator **10** reduces the voltage $V_{GPM2}$ at the gate of transistor **PM2**, in a manner substantially like that shown, in response to changes in voltage $V_{OUT}$ at **t0** and **t1**.

The effect is to switch on transistor **PM2** in a manner proportional to the slew rate of voltage $V_{OUT}$ sensed by the voltage differentiator **10**. Transistor **PM2** takes control of the voltage of the gate of transistor **PM1** from operational amplifier **1** and operational amplifier **1** acts as a current sink for transistor **PM2.**

The voltage on the gate, more precisely the gate-substrate voltage, of transistor **PM1** is thus limited which results in a limitation of the drain current of transistor **PM1** flowing into capacitor **C1.** This means that the output voltage varies slower, substantially as shown by **V$_{OUT}$.** As a consequence, the peaks **24** of current **I$_{OUT}$** drawn from supply **VDD** are reduced.

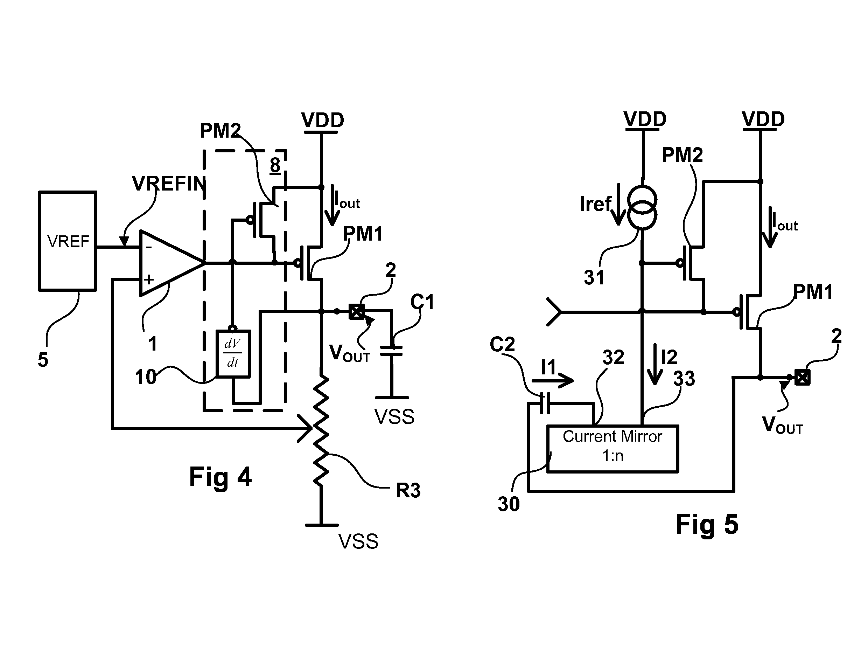

Fig 4 shows another LDO with an embodiment where voltage scaling is performed differently than in Fig 2. The resistor bridge, **R1** and **R2** is replaced by a multi-tap resistor bridge **R3** having a number of intermediate taps and the reference voltage to operational amplifier **1** is provided by a fixed voltage reference **5** (VREF). One of the intermediate taps of the multi-tap resistor bridge **R3** is connected to the non-inverting input of the operational amplifier **1** so as to set the gain of the operational amplifier **1.** By connecting the non-inverting input of the operational amplifier **1** to a different intermediate tap of the multi-tap resistor bridge **R3,** the gain of the operational amplifier **1** can be varied so as to obtain a variation of voltage **VOUT,** i.e. voltage scaling, without changing the voltage **VREFIN.**

Fig 5 shows an exemplary differentiator, usable in an embodiment. Between the output pad **2** and an input branch **32** of a current mirror **30** (current mirror 1: n), is connected a capacitor **C2.** To the gate of transistor **PM2** is connected an output branch **33** of the current mirror **30.** A current source **31,** supplying a current **Iref,** is connected between the gate of transistor **PM2** and supply **VDD.**

The change of voltage **V$_{OUT}$** is converted into a current **I1** by capacitor **C2** and fed into the input branch **32** of the current mirror **30** which, in turn, multiplies it by a predetermined ratio to create a current **I2.** When current **I2** is greater than current **Iref,** the voltage at the gate of transistor **PM2** is reduced and transistor **PM2** is turned on accordingly.

Referring back to Fig 3, whenever the voltage **V$_{OUT}$** starts to change, the current **I2** increases rapidly and voltage **V$_{GPM2}$** drops rapidly. This negative feedback loop then stabilizes to a stable state condition where **I2** is equal to **Iref** and voltage **V$_{GPM2}$** and the slew rate of voltage **V$_{OUT}$** are constant. Eventually voltage **V$_{OUT}$** becomes close to its target value and transistor **PM1** starts to be shut down. This reduces the slew rate which shuts down the slew rate control circuitry. Finally operational amplifier **1** takes control again and the voltage **V$_{OUT}$** becomes constant, the slew rate control circuitry is shut off completely and voltage **V$_{GPM2}$** is close to the voltage at **VDD.**

The operation of this embodiment is described by the equations below;

In the stable state condition, the current I1 is given by

$$I1 = C2 \cdot \frac{dV_{OUT}}{dt}$$

Via the current mirror **30** we have

$$I1 = \frac{Iref}{n}$$

Where **Iref** is the current supplied by the current source **31** and n is the ratio of the current mirror **30.**
Thus we have

$$\cdot \frac{dV_{OUT}}{dt} = SLR = \frac{Iref}{n.C2}$$

where SLR is the slew rate of **V$_{OUT}$.**

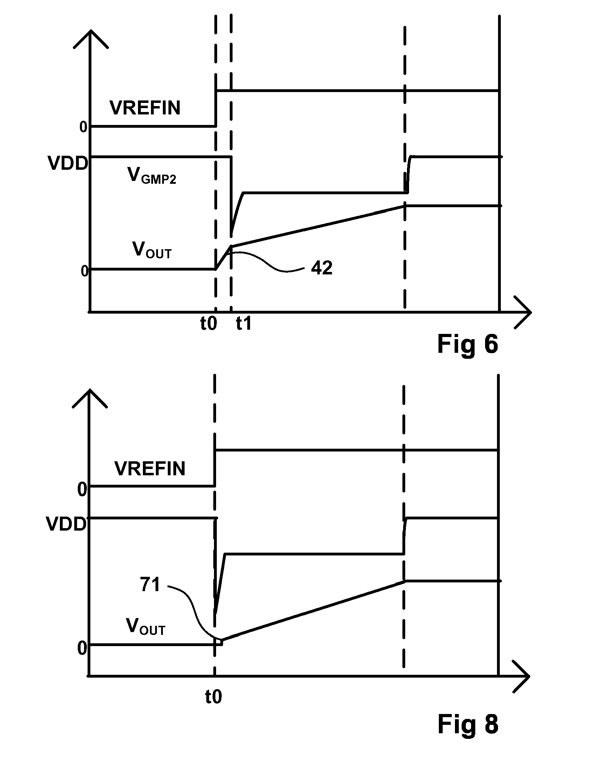

Fig 6 shows a parasitic effect due to the fact that whenever the voltage **Vout** starts to change, the current mirror **30** does not operate until the voltage on the input branch **32** of the current mirror **30** reaches a certain value. For example, at start up **t0,** the voltage **VREFIN** increases rapidly. The slew rate control circuitry does not start to operate and voltage **V$_{GPM2}$** does not start to drop until time **t1** when the voltage **V$_{OUT}$** and hence the voltage on the input branch **32** of the current mirror **30** have reached approximately one nMOS transistor threshold voltage above the negative supply **VSS.** This manifests itself as a sharp rise **42,** or step, of voltage **V$_{OUT}$** followed by a controlled ramp when the voltage **V$_{OUT}$** has reached a sufficient level for the current mirror **30** to operate and control the slew rate.

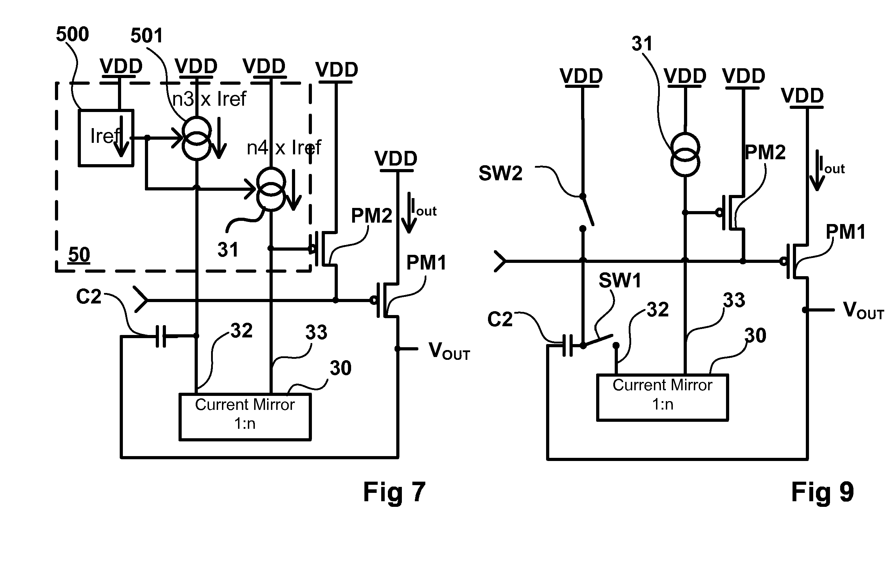

Fig 7 shows a solution to overcome the above parasitic effect. A multiple-output current mirror **50** comprises a current reference **500** (Iref) and two current sources, **501** and **31.** The current reference **500,** from which is drawn a current **Iref,** is coupled to current sources **501** and **31** so that they supply currents **Iref** x **n3** and **Iref** x **n4** respectively, where n3 and n4 are factors determined by the transistor geometries. Current source **501** is connected between positive supply **VDD** and the input branch **32** of the current mirror **30.** Current source **31** is coupled between supply **VDD** and a node coupled to both the output branch **33** of current mirror **30** and a controlling node of transistor **PM2.**

Current source **501** supplies current to the input branch **32** of current mirror **30.** This means that the current mirror is biased, i.e. the voltage on the input branch **32** is at least one nMOS threshold voltage above the negative supply **VSS.** Therefore it can operate without needing the biasing via capacitor **C2,** and in theory, the control of the slew rate of voltage **V$_{OUT}$** can start immediately as voltage **V$_{OUT}$** starts to change. In fact, there is still a slight delay in the slew rate control caused by the response time of the current mirror, and a small step still occurs.

Fig 8 represents the variation with time of voltages and currents during start-up when an embodiment is used with the elements shown in Fig 7.

The voltage **VREFIN** is increased at start-up **t0.** Because the control of the slew rate starts much earlier, there is a substantially smaller step **71** in the voltage $V_{OUT}$. Thus, the voltage $V_{GPM2}$ is reduced very soon after **t0.**

For the solution shown in Fig 7, the slew rate SLR of voltage $V_{OUT}$ is given by;

$$.SLR \; = \; \frac{(n1.n4 - n2.n3)}{\dfrac{n2}{n1}} \frac{Iref}{C2}$$

One of ordinary skill will be able to choose numbers **n3** and **n4** along with the other components of the circuits so that the current mirror **30** is correctly biased at start-up and can provide the desired slew rate limiting.

Fig 9 shows another solution to the above parasitic effect. Capacitor **C2** is connected via a first switch **SW1** to the input branch **32** of the current mirror **30** and via a second switch **SW2** to supply **VDD.**

Before the power-up phase, the first switch **SW1** is open and the second switch **SW2** is closed, thus capacitor **C2** is charged up to positive supply **VDD.** When the start-up phase is initiated, switch **SW2** is opened and switch **SW1** is closed, causing capacitor **C2** to be discharged into the input branch **32** of the current mirror **30,** which ensures sufficient current in the input branch **32** of current mirror **30.** This permits the output branch **33** of current mirror **30** to sink current, thereby turning on transistor **PM2** which then turns off completely transistor **PM1.** This has the effect that $V_{OUT}$ does not start to change immediately.

After a certain time, capacitor **C2** is discharged to a point where the voltage on the input branch **32** of current mirror **30** is approximately an nMOS threshold voltage above the negative supply **VSS.** At this point, the feedback loop of the slew rate control starts to work, transistor **PM1** is turned on and voltage $V_{OUT}$ starts to change with slew rate controlled in the manner described above.

Once the steady state value of voltage $V_{OUT}$ has been reached the current mirror **30** switches off and the current source **31** turns off automatically.

The solution represented in Fig 9 suffers less from offsets in the currents caused by matching differences between components, however it works less well for voltage scaling than the solution represented in Fig 7. The solution represented in Fig 7 works better during voltage scaling but requires more attention to component matching.

The above description shows only embodiments that control the slew rate of increases of voltage

$V_{OUT}$. However, one ordinarily versed in the art will appreciate that an implementation which limits the slew rate when voltage $V_{OUT}$ is decreasing can be obtained by connecting an nMOS transistor device between the output of the operational amplifier **1** and negative supply **VSS** or indeed connecting MOS transistor devices to both positive supply **VDD** and negative supply **VSS** to obtain control of the slew rate in both directions.

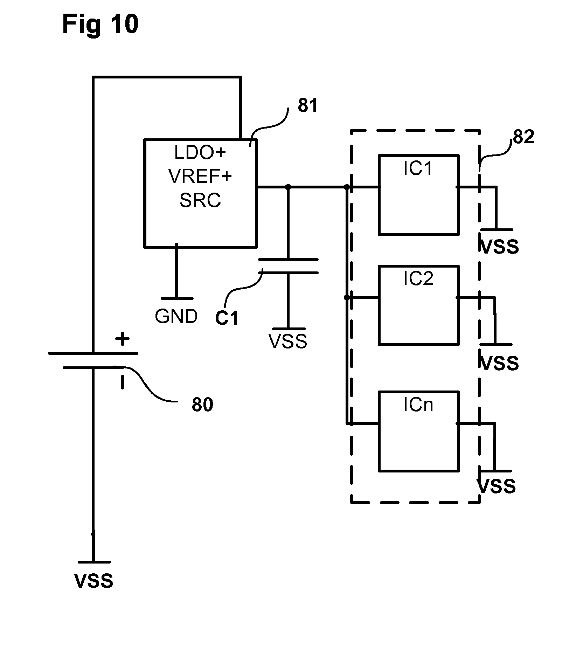

Figure 10 shows a battery powered mobile device containing a voltage regulator incorporating one of the embodiments. Amongst other circuits, the mobile device has a battery **80** with its negative terminal connected to negative supply **VSS** and its positive terminal connected to a voltage regulator **81** (LDO+VREF+SRC) incorporating an embodiment. To the output of the voltage regulator **81,** are connected, firstly the first plate of a filter capacitor **C1** and, secondly, the positive supply terminals of a plurality of electronic circuits **82** (IC1-ICn). The second plate of capacitor **C1** is connected to negative supply **VSS.**

The individual members of the plurality of electronic circuits **82** have their negative supply terminals coupled to the negative supply **VSS.** The positive terminal of the battery **80** may be connected to other circuits which are not shown here. The voltage regulator **81** may be implemented wholly or partially in integrated circuit form or as discrete components.

The detailed description set forth above, with the appended drawings, is intended to provide a description of the preferred embodiments and features, and is not intended to represent the only form nor imply the only combination of the features. It is to be understood that the same function may be accomplished by different embodiments which are intended to be encompassed by the scope of the present invention. For instance, voltage regulators are discussed here in detail but this invention could be implemented with other circuits, for example, but not limited to, an amplifier, which has an output having to drive a load, in order to control the slew rates of that output whenever the voltage at that output is changed.

**Claims**

1. A circuit comprising:

   - an output stage (PM1);
   - a differentiator coupled between an output (2) of the output stage (PM1) and a control node of the output stage.

2. A circuit according to claim 1 wherein said differentiator comprises:

   - a limiting transistor (PM2) coupled between the control node of said output stage (PM1) and a first supply voltage (VDD)a current mirror (30) having an output branch (33) coupled to a control terminal of said limiting transistor;
- a capacitor (C2) having a first terminal coupled to the output (2) of the output stage (PM1) and a second terminal coupled to an input branch (32) of said current mirror (30); and
- a first current source (31) coupled between the first supply voltage (VDD) and said control terminal of the limiting transistor (PM2).

3. A circuit according to claim 2 further comprising:

- a first switch (SW1) coupled between the input branch (32) of the current mirror (30) and the second terminal of the capacitor (C2); and
- a second switch (SW2) coupled between the first supply voltage (VDD) and the second terminal of the capacitor (C2).

4. A circuit according to claim 2 further comprising:

- a second current source (501) coupled between the first supply voltage (VDD) and the input branch (32) of the current mirror (30); and
- a current reference (500) supplying a current reference value to first and second currents sources.

5. A circuit according to one of claims 1 to 4 further comprising:

- an amplifier (1) having an output coupled to a control node of said output stage (PM1);
- a voltage reference (VREF) coupled to an input of said operational amplifier (1); and
- a feedback loop from the output (2) of the output stage (PM1) to said input of the amplifier (1) that permits the circuit to function as a voltage regulator.

6. A circuit to which a slew rate limiting circuit (10, PM2) according to one of claims 1 to 6 is coupled having an output slew rate less than 10,000 volts per second.

7. A portable electronic equipment comprising a circuit according to one of claims 1 to 6.

8. A method of controlling the output slew rate of an output stage of a circuit, comprising the steps of:

- measuring the voltage at the output (2) of the output stage (PM1);
- differentiating the measured voltage to produce a differentiated value;
- limiting the slew rate of a voltage applied to a controlling node of said output stage (PM1), based on said differentiated value.

9. A method according to claim 8 wherein the step of limiting the slew rate of the voltage applied to said controlling node of the output stage (PM1) is achieved by supplying a current to said controlling node of the output stage in a manner proportional to the differentiated value.

10. A method according to claim 9 wherein the step of differentiating the measured voltage is achieved by differentiating the measured voltage to produce a current and multiplying the current by a predetermined value.

**Fig 1**

**Fig 2**

Fig 3

**Fig 4**

**Fig 5**

Fig 6

Fig 8

**Fig 7**

**Fig 9**

**Fig 10**

Europäisches
Patentamt

European
Patent Office

Office européen
des brevets

# EUROPEAN SEARCH REPORT

Application Number

EP 08 30 5162

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 926 826 A (ABB RESEARCH LTD [SE]) 30 June 1999 (1999-06-30) * the whole document * | 1-10 | INV. G05F1/46 H03K17/082 |
| A | US 6 040 686 A (SCHENKEL JEFFREY [US]) 21 March 2000 (2000-03-21) * the whole document * | | |
| A | J WEBSTER: "Wiley Encyclopedia of Electrical and Electronics Engineering" [Online] 1999, JOHN WILEY & SONS, INC , XP002496975 Retrieved from the Internet: URL:http://mrw.interscience.wiley.com/emrw /9780471346081/home/> [retrieved on 2008-09-23] * page 391 - page 393 * | | |
| A | JP 07 135452 A (NIPPON ELECTRIC CO) 23 May 1995 (1995-05-23) * the whole document * | | TECHNICAL FIELDS SEARCHED (IPC) G05F H03K |
| X | EP 0 508 171 A (SIEMENS AG [DE]) 14 October 1992 (1992-10-14) * the whole document * | 1,7 | |

The present search report has been drawn up for all claims

| Place of search | Date of completion of the search | Examiner |
|---|---|---|
| The Hague | 24 September 2008 | Arias Pérez, Jagoba |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 08 30 5162

This annex lists the patent family members relating to the patent documents cited in the above-mentioned European search report.
The members are as contained in the European Patent Office EDP file on
The European Patent Office is in no way liable for these particulars which are merely given for the purpose of information.

24-09-2008

| Patent document cited in search report | | Publication date | Patent family member(s) | | Publication date |
|---|---|---|---|---|---|
| EP 0926826 | A | 30-06-1999 | NONE | | |
| US 6040686 | A | 21-03-2000 | EP | 1018799 A2 | 12-07-2000 |
| | | | JP | 3270440 B2 | 02-04-2002 |
| | | | JP | 2000217341 A | 04-08-2000 |
| JP 7135452 | A | 23-05-1995 | JP | 2812162 B2 | 22-10-1998 |
| EP 0508171 | A | 14-10-1992 | DE | 59208641 D1 | 31-07-1997 |
| | | | JP | 3187128 B2 | 11-07-2001 |
| | | | JP | 5102822 A | 23-04-1993 |
| | | | US | 5390070 A | 14-02-1995 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- FR 2872305